# FASCICULE DE BREVET EUROPEEN

(11) **EP 1 576 420 B1**
(45) Date de publication et mention de la délivrance du brevet: **09.08.2006**
(21) Numéro de dépôt: 03799684.0
(22) Date de dépôt: 22.12.2003
(51) Int. Cl.: G03F 7/00, B29C 59/02, B81C 1/00, G03F 7/09

(54) **PROCEDE DE LITHOGRAPHIE PAR PRESSAGE D'UN SUBSTRAT METTANT EN OEUVRE UNE NANO-IMPRESSION**
LITHOGRAFIEVERFAHREN DURCH PRESSEN EINES SUBSTRATS IN EINEM NANOIMPRINT-PROZESS
NANO-IMPRINT LITHOGRAPHY METHOD INVOLVING SUBSTRATE PRESSING

(30) Priorité: 23.12.2002 FR 0216540
(43) Date de publication de la demande: 21.09.2005
(73) Titulaire: COMMISSARIAT A L'ENERGIE ATOMIQUE, 75752 Paris Cédex 15 (FR); CENTRE NATIONAL DE LA RECHERCHE SCIENTIFIQUE (CNRS), 75016 Paris (FR)
(72) Inventeur: PERRET, Corinne, f-38950 Quaix-En-Chartreuse (FR); GOURGON, Cécile, F-38110 Cessieu (FR); LANDIS, Stephan, F-38110 La-Tour-du-Pin (FR)
(74) Mandataire: Quantin, Bruno Marie Henri
(86) Numéro de dépôt international: PCT/FR2003/003866
(87) Numéro de publication internationale: WO 2004/059386

(56) Documents cités:
- WO-A-01/79933
- US-A- 5 772 905
- US-A1- 2002 170 880
- LEBIB A ET AL: "Tri-layer systems for nanoimprint lithography with an improved process latitude" MICROELECTRONIC ENGINEERING, ELSEVIER PUBLISHERS BV., AMSTERDAM, NL, vol. 53, no. 1-4, juin 2000 (2000-06), pages 175-178, XP004237747 ISSN: 0167-9317 cité dans la demande

## Description

L'invention concerne la nano-impression (aussi appelée Nanolmprint Lithography, ou NIL), qui est une technique de lithographie par pressage de substrats dans les microtechnologies.

Cette technique présente divers avantages par rapport aux méthodes connues : elle permet d'obtenir les mêmes résolutions que la lithographie électronique, tout en étant beaucoup plus rapide et de moindre coût. En pratique, l'objectif est de réaliser des nanostructures (donc à une échelle inférieure au micron, typiquement quelques dizaines à quelques centaines de nanomètres) sur de grandes surfaces. Elle peut avoir notamment des applications dans la réalisation d'éléments de stockage magnétique à haute densité, de composants optiques à base de cristaux photoniques et dans les biotechnologies.

La nano-impression consiste à presser un moule dans un polymère recouvrant un substrat, en silicium ou en un autre matériau approprié. Le moule est typiquement réalisé en silicium par les techniques de lithographie/gravure standards. Ce moule est pressé dans une couche de polymère chauffé au delà de sa température de transition vitreuse en sorte d'être déformable. Après refroidissement et démoulage, les motifs du moule se retrouvent imprimés en négatif dans le polymère.

Afin d'éviter un contact qui pourrait être destructif entre le moule et le substrat qui supporte le polymère, une fine couche résiduelle de polymère est laissée volontairement au fond des motifs en saillie du moule. En effet, les pressions appliquées au moule sont telles que, si le moule et le substrat venaient en contact direct, les deux plaques seraient fragilisées et pourraient se casser. Pour garantir la présence de cette couche résiduelle, l'épaisseur initiale de polymère est choisie de telle sorte que, en fin de pressage, le polymère remplisse les creux des motifs du moule.

L'épaisseur résiduelle de polymère est ensuite éliminée par un plasma d'oxygène, ce qui met localement à nu le substrat. Les motifs de la couche de polymère sont alors reproduits (on dit qu'ils sont transférés) dans le substrat par gravure plasma (typiquement la technique connue sous le signe RIE pour "Reactive Ion Etching"), comme dans le cas d'une lithographie/gravure habituelle.

Une telle technique est décrite dans le document "Imprint of sub-25nm vias and trenches in polymers" de S. Y. CHOU, P. R. KRAUSS, and P. J. RENSTROM, paru dans Appl. Phys. Lett. 67 (21) 20 november 1995, pp. 3114-3116.

La difficulté principale de cette technique est d'obtenir une épaisseur résiduelle uniforme , quelques soient la taille et la densité des motifs pressés. En effet, si l'épaisseur résiduelle en fond de motif n'est pas homogène, le plasma d'oxygène qui vise à l'éliminer induira une modification locale de la taille des motifs là où cette couche est la plus fine ; or cette diminution de taille, à propos de motifs a priori inconnus, ne peut pas être prise en compte dans le dimensionnement des motifs du moule. Il en découle une imprécision dans le contrôle des dimensions des motifs qui est incompatible avec une utilisation industrielle de cette technique.

Cette modification erratique de la taille des motifs de la couche de polymère peut s'expliquer comme suit.

Tout d'abord, les différences locales dans l'épaisseur résiduelle proviennent du fait que plus les saillies et les creux du motif du moule sont rapprochés, plus la pénétration du moule dans la couche de polymère implique le déplacement d'une quantité importante de matière, et plus le moule a du mal "à entrer" dans la couche de polymère.

Lors de l'étape de gravure en plasma d'oxygène de cette couche résiduelle en fond de motif, il y a élimination en chaque endroit de la matière polymère en direction du substrat. Mais lorsqu'en un endroit où la couche résiduelle est initialement très fine, la surface sous-jacente du substrat a été mise à nu, la continuation de l'application du plasma (nécessaire pour éliminer la couche résiduelle là où elle est la plus épaisse) se traduit par une attaque désormais latérale du polymère, ce qui se traduit localement par un agrandissement des creux du motif. En conséquence les motifs les plus isolés (où la couche résiduelle a été la plus fine) sont diminués par rapport aux saillies du moule, alors que les motifs les plus denses (où la couche résiduelle a été la plus épaisse) sont maintenus identiques par rapport aux saillies du moule.

Cette disparité d'épaisseur est très difficile à éviter. En fait, les principaux paramètres du pressage sont la pression, la température et le temps de pressage. Des essais ont montré que, si l'on veut graver des lignes de 500 nm de largeur, avec un espace entre les lignes qui varie entre 650 nm et 10 000 nm, sous une pression de 50 bars à 120 °C, l'épaisseur résiduelle varie entre 55 et 120 nm pour une durée de pression de 5 minutes, entre 40 à 75 nm pour une durée de 30 minutes, et entre 65 et 75 nm pour une durée de 60 minutes. Cela montre, d'une part la disparité d'épaisseur (le maximum est généralement observé pour un écart entre les lignes qui est de l'ordre de 1000 nm), mais aussi que, cette disparité diminue lorsque l'on augmente la durée de pressage.

Il apparaît ainsi qu'il est possible d'obtenir un pressage sensiblement uniforme dans un réseau, mais que cela implique des températures et des durées (plus la température est élevée, moins la durée de pressage a besoin d'être longue) pouvant apparaître trop élevées et donc trop coûteuses.

Cela rend cette technique moins rapide et donc moins avantageuse que les procédés standards.

Mais ce qui précède concerne un réseau d'une taille donnée, dont les motifs sont particuliers (des lignes uniquement, de même largeur), de sorte qu'il peut être conclu que, s'il est possible, avec des conditions bien adaptées, d'obtenir un réseau de lignes uniformément pressées dans des tailles données, il est quasiment impossible d'avoir avec les mêmes conditions une épaisseur résiduelle de même valeur dans des réseaux de taille et de densité de motifs différentes, et a fortiori avec des motifs de formes diverses. En conséquence, l'étude complète de l'homogénéisation de pressage est à refaire en fonction des trois paramètres précités, dès que l'on change de taille de réseau ou de motifs de pressage.

Pour obtenir des impressions de bonne qualité, il a été proposé, notamment par le document "Tri-layer systems for nanoimprint lithography with an improved process latitude" de A. LEBIB, Y. CHEN, F. CARCENAC, E. CAMBRIL, L. MANIN, L. COURAUD et H. LAUNOIS, paru dans Mircoelectronic engineering 53 (2000) 175-178, d'utiliser une technique mettant en oeuvre trois couches sur le substrat que l'on veut graver : ce substrat est recouvert par une couche inférieure de résine PMGI cuite à 270°C, elle-même recouverte d'une fine couche de germanium, elle-même recouverte par une couche supérieure de résine PMMA ou S1805. Le procédé comporte de multiples étapes : pressage du moule dans la seule couche supérieure, élimination du résidu de la partie imprimée de la couche supérieure, transfert du motif dans la couche de germanium par attaque de cette couche intermédiaire en utilisant la couche supérieure comme masque, et cette couche de germanium sert ensuite de masque pour l'attaque de la couche inférieure. Il y a ensuite dépôt d'une couche métallique sur la couche inférieure puis élimination de cette couche inférieure : les portions de cette couche métallique qui ont été au fond des creux de cette couche, sur la surface du substrat, sont les seules à subsister et servent enfin de masque pour l'attaque du substrat. Il faut noter que c'est un procédé de nature différente de celui précédemment décrit puisque ce n'est pas la couche inférieure qui sert, par ses portions en saillie, de masque pour l'attaque du substrat, mais les portions métalliques directement déposées sur ce substrat, correspondant aux creux de cette couche inférieure. Cette technique impliquant un dépôt au fond des creux de la couche inférieure est souvent désignée sous la désignation anglaise de "lift-off".

L'invention a pour objet un procédé de lithographie par pressage d'un substrat, capable d'être mis en oeuvre à l'échelle industrielle avec un nombre modéré d'opérations, qui conduise à une bonne précision des motifs lithographiés puis pressés, pour des pressions, des temps et des températures de pressage modérés.

L'invention propose à cet effet un procédé de pressage d'un substrat comportant une étape de préparation au cours de laquelle ce substrat est recouvert d'une couche, une étape de pressage d'un moule muni d'un motif constitué de creux et de saillies sur une partie seulement de l'épaisseur de la couche, au moins une étape d'attaque de cette couche jusqu'à dénuder des parties de la surface du substrat, et une étape de gravure du substrat selon un motif de gravure défini à partir du motif du moule, caractérisé en ce que l'étape de préparation comporte une sous-étape de formation d'une sous-couche inférieure en un matériau durcissable, une étape de durcissement de cette sous-couche, et une sous-étape de formation d'une sous-couche externe qui est adjacente à cette sous-couche durcie, l'étape de pressage comportant la pénétration des saillies du moule dans cette sous-couche externe jusqu'au contact avec cette sous-couche inférieure durcie.

On peut noter que la mise en oeuvre d'une couche de matériau durcissable ayant subi un traitement de durcissement n'est en soi pas nouvelle dans le domaine de la nano-impression, puisque le document précité de LEBIB et al. enseignait l'empilement de trois couches dont la couche inférieure avait fait l'objet d'un traitement de recuit. Par contre, il n'avait pas encore été proposé de mettre à profit la dureté d'une telle couche pour en faire une couche d'arrêt lors du pressage du moule, puisqu'il est précisé dans ce document que, pour éviter que le moule ne vienne en contact avec le substrat, l'épaisseur de la couche supérieure est légèrement supérieure à la profondeur de moule, et il est même précisé, ainsi que cela a été déjà mentionné, qu'on enlève le résidu de la couche supérieure avant de s'en servir de masque pour l'étape d'attaque de la couche sous-jacente ; ce document ne divulguait donc pas d'utiliser une couche d'arrêt pour le pressage (pas même celle en germanium), et a fortiori ne divulguait pas d'utiliser une couche d'arrêt en polymère durci.

L'invention apporte une simplification par rapport aux solutions connues, y compris dans le cas des techniques de type "lift-off", puisqu'elle permet de contrôler avec précision la profondeur de pénétration du moule en tout point de la couche, ce qui contribue à obtenir une grande précision dans la reproduction lors de la gravure du motif du moule.

Toutefois, l'invention est tout particulièrement intéressante lorsque, comme dans la technique décrite au début, la couche imprimée sert de masque pour la gravure du substrat, ce qui correspond à un procédé bien plus simple et bien plus rapide que ceux du type "lift-off". Un cas avantageux de l'invention est donc celui où on forme cette sous-couche inférieure en contact avec la surface du substrat, et en ce que, lors de l'étape d'attaque, on creuse la sous-couche inférieure au travers des creux de la sous-couche externe et, lors de l'étape de gravure, on attaque le substrat au travers de ces mêmes creux.

Une simplification complémentaire est obtenue lorsque la sous-couche inférieure et la sous-couche externe sont réalisées en un même matériau, auquel cas il n'y a à prévoir qu'un seul matériau, les deux sous-couches étant différentiées par le fait que l'une d'entre elles est durcie, l'autre pas ; cela simplifie en outre le choix du mode d'attaque du substrat, puisqu'il suffit de vérifier qu'il est compatible avec ce matériau commun.

De manière préférée, le traitement de durcissement comporte un traitement thermique de la sous-couche inférieure à une température supérieure à sa température de durcissement, l'étape de pressage étant réalisée à une température de pressage légèrement supérieure à la température de transition vitreuse de la sous-couche externe. De manière préférée, ce matériau est un polymère, par exemple une résine réticulable. Il s'agit par exemple d'une résine négative ; il peut aussi s'agir d'une résine positive.

L'épaisseur minimale de la sous-couche inférieure pour qu'elle puisse servir efficacement de couche d'arrêt varie selon divers paramètres, dont la pression de pressage et la nature du matériau polymère ; par ailleurs il est recommandé que cette épaisseur ne soit pas beaucoup plus importante que ce minimum de manière à ne pas allonger inutilement le temps d'attaque de cette sous-couche pour mettre localement à nu la surface du substrat. Compte tenu de ces commentaires, il est avantageux que cette sous-couche inférieure ait une épaisseur comprise entre 0,01 et 1 micron.

Pour faciliter la pénétration du moule dans la sous-couche externe jusqu'à la sous-couche interne, cette épaisseur de la sous-couche externe est avantageusement inférieure à la profondeur des creux du motif du moule.

Le substrat est de préférence en silicium, qui est un matériau très bien connu dans les applications micro-électroniques. Toutefois le matériau constitutif du substrat (du moins en ce qui concerne sa partie à graver) peut être choisi dans une grande gamme de matériaux utilisable dans les microtechnologies, parmi lesquels on peut citer le germanium ou les alliages SiGe (avec des proportions variées), InP, AsGa, etc...

Des objets, caractéristiques et avantages de l'invention ressortent de la description qui suit, donnée en regard du dessin annexé sur lequel :
- la figure 1 est une vue schématique d'une première étape du procédé de l'invention, selon laquelle on positionne un moule sur une couche formée sur un substrat,
- la figure 2 est une vue schématique d'une seconde étape selon laquelle on presse le moule dans la couche jusqu'à une sous-couche d'arrêt,
- la figure 3 est une vue schématique d'une troisième étape selon laquelle, après démoulage, on attaque la sous-couche d'arrêt,
- la figure 4 est une vue schématique d'une quatrième étape selon laquelle on grave le substrat, et
- la figure 5 est un graphique corrélant l'épaisseur résiduelle après pressage du moule en fonction des caractéristiques du motif à reproduire.

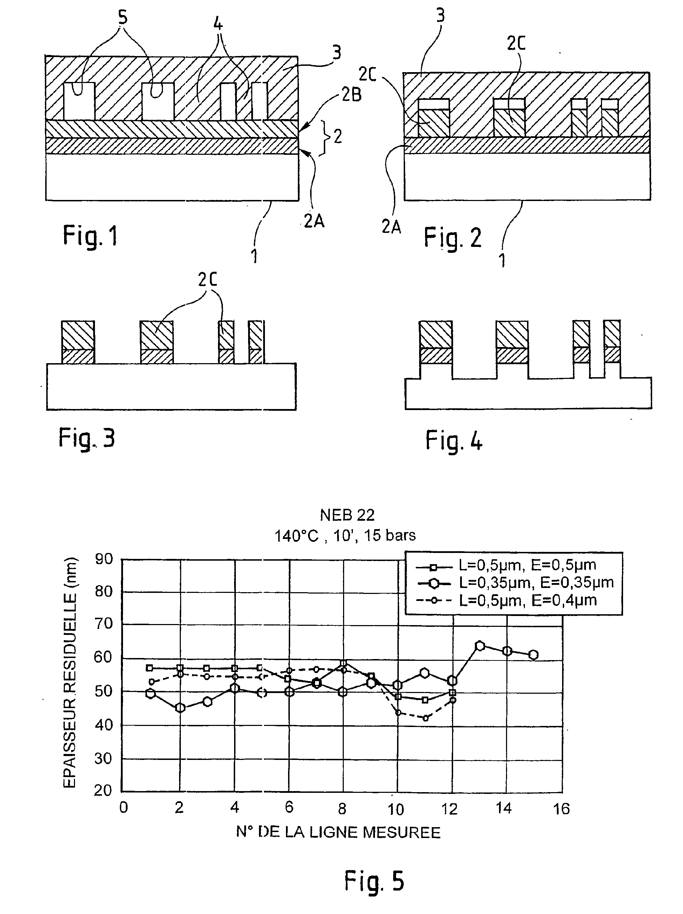

Les figures 1 à 4 représentent quatre stades du procédé de l'invention, mettant en oeuvre un substrat 1 sur lequel on a formé une couche 2, et un moule 3 muni d'un motif formé de saillies 4 et de creux 5 définissant un motif selon lequel on veut graver le substrat. Le substrat et le moule sont ici en un même matériau, par exemple en silicium.

La figure 1 représente une étape dans laquelle la couche 2 a déjà été formée sur le substrat, sous la forme de deux sous-couches, à savoir une sous-couche intérieure 2A et une couche externe 2B, et dans laquelle le moule est positionné sur cette couche, au moment de commencer le pressage.

La couche intérieure est formée en un matériau durcissable. Cette couche est d'abord formée sur la surface libre du substrat (avec ou non une couche d'oxyde naturel), puis traitée en sorte de durcir.

Ce matériau peut être un polymère ou tout autre matériau plus mou que le matériau du substrat (au moins dans sa partie superficielle). Lorsqu'il s'agit d'un polymère, le traitement de durcissement est un traitement thermique à une température supérieure à sa température de durcissement. Ce polymère est de préférence choisi en sorte d'avoir une température de transition vitreuse supérieure à la température à laquelle va être fait le pressage. Il est par ailleurs choisi en sorte de pouvoir, après pressage, être attaqué en sorte de dénuder localement la surface du substrat, par exemple par plasma d'oxygène. Il s'agit avantageusement d'une résine réticulable.

Après traitement de durcissement de cette sous-couche inférieure 2A, on forme sur cette couche durcie la sous-couche 2B qui est destinée à constituer la partie externe du revêtement du substrat.

Cette sous-couche externe est réalisée en tout matériau connu approprié, par exemple un polymère thermoplastique, capable d'être déformé, éventuellement après chauffage au dessus d'un seuil de ramollissement. Il peut s'agir d'un polymère ou d'une résine réticulable.

De manière tout à fait avantageuse, cette sous-couche externe est formée dans le même matériau utilisé pour former la sous-couche inférieure, à ceci près que l'on applique pas de traitement de durcissement à cette sous-couche externe, y compris lors de l'éventuel chauffage pour le pressage.

Le matériau constitutif de ces deux couches est avantageusement une résine négative couramment utilisée en micro-électronique, qui possède un agent réticulant thermiquement activé. Lorsque l'on chauffe la résine au dessus de sa température de réticulation, l'agent réticulant devient actif et lie entre elles les macromol7cules. Celles -ci ne pouvant plus se déplacer, le polymère devient dur et ce, de façon irréversible.

En pratique, que la sous-couche externe soit dans le même matériau que la sous-couche inférieure, ou non, elle fait avantageusement l'objet d'un traitement standard, impliquant un traitement thermique, insuffisant pour induire un durcissement, mais suffisant pour stabiliser le polymère.

La figure 2 représente un stade où le pressage (après éventuel échauffement) a eu lieu et s'est poursuivi jusqu'à venue des saillies du moule en contact avec la couche d'arrêt 2A. Lors de ce pressage cette couche d'arrêt joue un rôle d'amortisseur.

On observe que les creux du moule, entre les saillies, sont incomplètement remplis du matériau constitutif de la sous-couche externe. En effet, les creux du moule ont une profondeur supérieure à l'épaisseur de la sous-couche externe, ce qui évite que la pénétration des saillies de ce moule dans cette sous-couche soit bloquée par les bourrelets 2C de matière refoulée dans ces creux. Ainsi, quelle que soit la densité des motifs du moules, isolés ou denses, le pressage peut donc facilement s'effectuer sur l'ensemble du substrat, même lorsque celui-ci est de grandes dimensions. Suite à son durcissement, la couche d'arrêt est suffisamment dure pour résister à une pénétration par les saillies, tout en restant suffisamment élastique pour absorber la pression appliquée. On garantit bien que toutes les saillies viennent à une distance donnée de la surface du substrat (l'épaisseur de cette couche d'arrêt - voir aussi la figure 5), sans pour autant risquer de contact entre le moule et le substrat, donc de dégradation entre ces éléments.

Il est à noter que, plus la différence entre l'épaisseur de la sous-couche et la profondeur des creux du moule est importante, plus le risque qu'il y ait localement remplissage complet de ces creux est faible, et plus facile est le démoulage ultérieur. A titre complémentaire, puisque les creux ne se remplissent pas, les contraintes mécaniques au sein du moule restent sensiblement uniformes lors du pressage, de sorte que ce moule ne se déforme quasiment pas, ce qui accroît sa durabilité.

Il est apparu possible d'obtenir un bon contact entre les saillies du moule et la couche d'arrêt, sans détérioration de celle-ci.

Les figures 3 et 4 représentent la suite du procédé de gravure du substrat, reprenant des étapes connues en soi.

A la figure 3, le moule a été retiré, ne laissant subsister que les bourrelets de la matière de la sous-couche qui se sont formés dans les creux du moule. En utilisant ces bourrelets comme masque d'attaque, on a attaqué, par exemple par plasma d'oxygène (le substrat étant en silicium), la couche d'arrêt, jusqu'à dénuder localement le substrat.

A la figure 4, les creux ménagés dans la couche d'arrêt ont été utilisés comme masque pour l'attaque du substrat, par tout moyen connu approprié tel que l'attaque au plasma classiquement utilisée en lithographie, selon un motif qui est défini par celui du moule, en ce sens que les creux du substrat correspondent très exactement aux saillies du moule.

Il est ainsi possible d'obtenir les performances voulues en précision avec des pressions plus faibles que dans les solutions connues, par exemple 5 minutes au lieu de 30 minutes, sous 15 bars au lieu de 50 bars. Le dimensionnement de l'installation de pressage s'en trouve simplifié et son encombrement réduit.

La figure 5 représente les résultats obtenus pour diverses configurations : un ensemble de lignes dans le moule dont la largeur L varie entre 0.35 et 0.5 microns, une épaisseur E entre les lignes qui varie entre 0.35 et 0.5 microns suite à un pressage de 10 minutes à 140 °C sous 15 bars, les sous-couches externe et inférieure étant en une même résine négative. Lorsque l'on mesure l'épaisseur résiduelle de la sous-couche d'arrêt finalement obtenue après contact du moule avec celle-ci, on observe que celle-ci, malgré quelques fluctuations pouvant être attribuées à de possibles écrasements locaux différents entre les zones considérées, reste sensiblement uniforme d'une ligne à l'autre, comprise dans tous les cas dans une gamme de l'ordre de 40 à 60 nanomètres ; cela établit aussi que l'épaisseur de cette sous-couche d'arrêt peut n'être que de l'ordre de quelques dizaines de nanomètres, ce qui est très fin. Dans cet exemple :
épaisseur de la couche externe initiale : 100 nm
profondeur des motifs du moule : 250 nm

## Revendications

1. Procédé de lithographie par pressage d'un substrat comportant une étape de préparation au cours de laquelle ce substrat (1) est recouvert d'une couche, une étape de pressage d'un moule muni d'un motif constitué de creux et de saillies sur une partie seulement de l'épaisseur de la couche, au moins une étape d'attaque de cette couche jusqu'à dénuder des parties de la surface du substrat, et une étape de gravure du substrat selon un motif de gravure défini à partir du motif du moule, **caractérisé en ce que** l'étape de préparation comporte une sous-étape de formation d'une sous-couche inférieure (2A) en un matériau durcissable, une étape de durcissement de cette sous-couche, et une sous-étape de formation d'une sous-couche externe (2B) qui est adjacente à cette sous-couche durcie, l'étape de pressage comportant la pénétration des saillies du moule dans cette sous-couche externe jusqu'au contact avec cette sous-couche durcie.

2. Procédé selon la revendication 1, **caractérisé en ce qu'**on forme cette sous-couche inférieure en contact avec la surface du substrat, et **en ce que**, lors de l'étape d'attaque, on creuse la sous-couche inférieure au travers des creux de la sous-couche externe et, lors de l'étape de gravure, on attaque le substrat au travers de ces mêmes creux.

3. Procédé selon la revendication 1 ou la revendication 2, **caractérisé en ce que** la sous-couche inférieure et la sous-couche externe sont réalisées en un même matériau.

4. Procédé selon l'une quelconque des revendications 1 à 3, **caractérisé en ce que** le traitement de durcissement comporte un traitement thermique de la sous-couche inférieure à une température supérieure à sa température de durcissement, l'étape de pressage étant réalisée à une température de pressage supérieure à la température de transition vitreuse de la sous-couche externe.

5. Procédé selon l'une quelconque des revendications 1 à 4, **caractérisé en ce que** ce matériau est un polymère.

6. Procédé selon l'une quelconque des revendications 1 à 5, **caractérisé en ce que** ce matériau est une résine réticulable.

7. Procédé selon la revendication 5 ou la revendication 6, **caractérisé en ce que** ce matériau est une résine négative ou une résine positive.

8. Procédé selon l'une quelconque des revendications 1 à 7, **caractérisé en ce que** cette sous-couche inférieure a une épaisseur comprise entre 0,01 et 1 micron.

9. Procédé selon l'une quelconque des revendications 1 à 8, **caractérisé en ce que** l'épaisseur de la sous-couche externe est inférieure à la profondeur des creux du motif du moule.

## Claims

1. Lithography method involving the pressing of a substrate, including a preparation step during which the substrate (1) is covered with a layer, a pressing step in which a mold comprising a pattern of recesses and protrusions is pressed so as to penetrate part of the thickness of the aforementioned layer, at least one attacking step in which the layer is attacked until parts of the surface of the substrate have been stripped, and an etching step whereby the substrate is etched using an etching pattern which is defined by the mold pattern, which method is **characterized in that** the preparation step comprises a sub-step consisting of the formation of a lower sub-layer (2A) of curable material, a step involving the curing of said sub-layer and a sub-step consisting of the formation of an outer sub-layer (2B) which is adjacent to the cured sub-layer, the pressing step including penetration of the above-mentioned protrusions of the mold into this external sub-layer until it comes into contact with this cured sub-layer.

2. Method according to claim 1, **characterized in that** this lower sub-layer is formed in contact with the surface of the substrate and **in that**, during the attacking step, the lower sub-layer is excavated through the recesses of the external sub-layer and, during the etching step, the substrate is attacked through the same recesses.

3. Method according to claim 1 or claim 2, **characterized in that** the lower sub-layer and the external sub-layer are made of the same material.

4. Method according to any one of claims 1 to 3, **characterized in that** the curing treatment includes heat treatment of the lower sub-layer at a temperature higher than its curing temperature and the pressing step is carried out at a pressing temperature higher than the glass transition temperature of the external sub-layer.

5. Method according to any one of claims 1 to 4, **characterized in that** the material is a polymer.

6. Method according to any one of claims 1 to 5, **characterized in that** the material is a resin that can be cross-linked.

7. Method according to claim 5 or claim 6, **characterized in that** the material is a negative resin or a positive resin.

8. Method according to any one of claims 1 to 7, **characterized in that** the lower sub-layer has a thickness from 0.01 micron to 1 micron.

9. Method according to any one of claims 1 to 8, **characterized in that** the thickness of the external sub-layer is less than the depth of the recesses of the pattern of the mold.

## Patentansprüche

1. Lithographieverfahren durch Pressen eines Substrats, umfassend einen Vorbereitungsschritt, in dem dieses Substrat (1) mit einer Schicht bedeckt wird, einen Schritt des Pressens einer Form, die mit einem aus Vertiefungen und Erhebungen bestehenden Muster versehen ist, nur auf einem Teil der Dicke der Schicht, mindestens einen Schritt des Angreifens dieser Schicht, bis Teile der Oberfläche des Substrats freigelegt werden, und einen Schritt des Gravierens des Substrats nach einem ausgehend von dem Muster der Form gebildeten Gravurmuster, **dadurch gekennzeichnet, dass** der Vorbereitungsschritt einen Unterschritt der Bildung einer unteren Unterschicht (2A) aus einem härtbaren Werkstoff, einen Schritt des Härtens dieser Unterschicht und einen Unterschritt der Bildung einer äußeren Unterschicht (2B) umfasst, die an diese gehärtete Unterschicht angrenzt, wobei der Pressschritt das Eindringen der Erhebungen der Form in diese äußere Unterschicht bis zum Kontakt mit dieser gehärteten Unterschicht umfasst.

2. Verfahren nach Anspruch 1, **dadurch gekennzeichnet, dass** man diese untere Unterschicht im Kontakt mit der Oberfläche des Substrats bildet und dass man in dem Angriffsschritt die untere Unterschicht durch die Vertiefungen der äußeren Unterschicht hindurch aushöhlt und man in dem Gravierschritt das Substrat durch ebendiese Vertiefungen hindurch angreift.

3. Verfahren nach Anspruch 1 oder Anspruch 2, **dadurch gekennzeichnet, dass** die untere Unterschicht und die äußere Unterschicht aus dem gleichen Werkstoff hergestellt sind.

4. Verfahren nach einem der Ansprüche 1 bis 3, **dadurch gekennzeichnet, dass** die Härtungsbehandlung eine thermische Behandlung der unteren Unterschicht bei einer Temperatur, die höher als ihre Härtungstemperatur ist, umfasst, wobei der Pressschritt bei einer Presstemperatur durchgeführt wird, die höher als die Glasübergangstemperatur der äußeren Unterschicht ist.

5. Verfahren nach einem der Ansprüche 1 bis 4, **dadurch gekennzeichnet, dass** dieser Werkstoff ein Polymer ist.

6. Verfahren nach einem der Ansprüche 1 bis 5, **dadurch gekennzeichnet, dass** dieser Werkstoff ein vernetzbares Harz ist.

7. Verfahren nach Anspruch 5 oder Anspruch 6, **dadurch gekennzeichnet, dass** dieser Werkstoff ein negatives Harz oder ein positives Harz ist.

8. Verfahren nach einem der Ansprüche 1 bis 7, **dadurch gekennzeichnet, dass** diese untere Unterschicht eine Dicke zwischen 0,01 und 1 Mikron besitzt.

9. Verfahren nach einem der Ansprüche 1 bis 8, **dadurch gekennzeichnet, dass** die Dicke der äußeren Unterschicht kleiner als die Tief der Vertiefungen des Musters der Form ist.
